Europäisches Patentamt

European Patent Office

Office européen des brevets

(19)

(11) Veröffentlichungsnummer: **0 260 426 B1**

## EUROPÄISCHE PATENTSCHRIFT

(12)

(45) Veröffentlichungstag der Patentschrift: 24.04.91

(51) Int. Cl.⁵: **G01N 24/08**

(21) Anmeldenummer: 87111354.4

(22) Anmeldetag: 05.08.87

(54) Verfahren zur Ermittlung von kernmagnetischen Spektren aus räumlich selektierbaren Bereichen eines Untersuchungsobjektes.

(30) Priorität: 18.08.86 DE 3627939
03.04.87 DE 3711243

(43) Veröffentlichungstag der Anmeldung:
23.03.88 Patentblatt 88/12

(45) Bekanntmachung des Hinweises auf die
Patenterteilung:
24.04.91 Patentblatt 91/17

(84) Benannte Vertragsstaaten:
DE FR GB NL

(56) Entgegenhaltungen:
EP-A- 0 086 306
EP-A- 0 097 519
JP-A-61 102 547

PHYSICS IN MEDICINE & BIOLOGY, Band 30,
Nr. 8, August 1985, Seiten 741-770, London,
GB; R.E. GORDON: "Magnets, molecules and
medicine"

E. FUKUSHIMA et al.: "Experimental pulse
NMR", 1981, Seiten 174-176, Addison-Wesley
Publishing Co. Inc., Reading, Massachusetts,
US

"ADVANCES IN MAGNETIC RESONANCE"
NMR IMAGING IN BIOMEDICINE; SUPPLE-
MENT 2, P.M. MANSFIELD und P.G. MORRIS,
ACADEMIC PRESS, 1982; Seiten 93, 94

(73) Patentinhaber: **Siemens Aktiengesellschaft**
**Wittelsbacherplatz 2**
**W-8000 München 2(DE)**

(72) Erfinder: **Weber, Horst, Dr.**
**Am Fürstenberg 7**
**W-8555 Adelsdorf(DE)**
Erfinder: **Sauter, Rolf, Dr. rer. nat.**
**Distelweg 17**
**W-8510 Fürth(DE)**

## Beschreibung

Die Erfindung betrifft ein Verfahren zur Ermittlung von kernmagnetischen Spektren aus räumlich selektierbaren Untersuchungsbereichen eines Untersuchungsobjektes, das mit einem magnetischen Grundfeld und einem Gradientenfeld sowie mit einer Folge von HF-Impulsen zur Anregung der kernmagnetischen Resonanz beaufschlagt wird, wobei das entstehende Kernresonanzsignal mit einer in der Nähe des Untersuchungsbereiches angeordneten Spule erfaßt wird und wobei die räumliche Selektion durch Überlagerung der Sende-Empfangs-Charakteristik der Spule mit einer selektiven Schichtanregung durch Aufschaltung eines Gradienten zusammen mit einem frequenzselektiven HF-Impuls erreicht wird.

Bei der kernmagnetischen Spektroskopie wird im allgemeinen keine volle Ortsauflösung angewandt. Gewünscht ist aber die Abgrenzung einzelner Volumenbereiche, z.B. eines Organs. Bei einem aus dem Artikel von P.A. Bottomley u.a. in Journal of Magnetic Resonance, Bd. 59, 1984, Seiten 338-342 bekannten Verfahren wird hierzu der gewünschte Volumenbereich selektiv angeregt. Der Empfang und auch das Aussenden der kernmagnetischen Signale erfolgt über eine am Körper angelegte Oberflächenspule. Dabei wird zur Volumenselektion auch die Empfangs-und die Sendecharakteristik der Oberflächenspule mit ausgenutzt. Wenn man daher bei der selektiven Anregung durch Aufschaltung eines Magnetfeld-Gradienten eine Schicht auswählt, so wird daraus aufgrund der Charakteristik der Oberflächenspule wiederum ein Ausschnitt selektiert.

Das bekannte Verfahren ist jedoch für die Spektroskopie von Verbindungen mit kurzer Relaxationszeit $T_2$ problematisch. Die selektive Anregung dauert nämlich verhältnismäßig lange. Dies ergibt sich daraus, daß ein HF-Impuls mit einer der Schichtdicke entsprechenden Bandbreite ausgesendet werden muß. Das FID-Signal, das erst nach dem Ende der Anregung ausgewertet werden kann, ist dann bei kurzen $T_2$-Zeiten schon relativ weit abgeklungen. Dies trifft vor allem für die in-vivo-Phosphorspektroskopie zu.

Aus der US-PS 40 21 726 ist es für die Bildgebung bekannt, daß eine räumliche Selektion auch durch Sättigung aller Spins außer in einer ausgewählten Schicht erreicht werden kann. Hierbei erfolgt das Auslesen der gewünschten Information mit einem 90°-Anregungsimpuls, der gleichzeitig mit einem Auslesegradienten angelegt wird. Dieses Verfahren eignet sich jedoch nicht für die Spektroskopie, da der Auslesegradient die spektrale Information zerstören würde.

Aus dem Buch "Advances in Magnetic Resonance, NMR Imaging in Biomedicine, Supplement 2", P. Mansfield et al, Academic Press, 1982, Seiten 93 und 94, ist ebenfalls die selektive Sättigung als eine Möglichkeit der Ortsselektion bei der Bildgebung bekannt. Zur Pulsformung der Sättigungsimpulse wird die Amplitudenmodulation vorgeschlagen. Die selektive Sättigung wird in dieser Literaturstelle jedoch als nachteilig bezeichnet, vor allem wegen der notwendigen großen Hochfrequenzleistung sowie der Störsignale aufgrund verbleibender Magnetisierung in dem zu sättigenden Bereich.

Aus dem Buch "Experimental Pulse NMR", E. Fukushima et al, Addison-Wesley Publishing Company, Inc., 1981, Seiten 194 bis 196, ist ein Verfahren bekannt, bei dem eine Sättigung mit Hilfe einer "kammförmigen" Pulssequenz von /2 Hochfrequenzimpulsen durchgeführt wird. Dabei gilt für den Impulsabstand $t_1$: $T_2^* < t_1 << T_1$.

Aufgabe der Erfindung ist es, ein Verfahren der eingangs genannten Art so auszugestalten, daß bei räumlich selektiver Spektroskopie das ungeschwächte FID-Signal ausgewertet werden kann.

Diese Aufgabe wird erfindungsgemäß durch folgende Verfahrensschritte gelöst:

a) nicht auszuwertende Volumenbereiche des Untersuchungsobjektes werden selektiv gesättigt

b) das Untersuchungsobjekt wird mit einem nicht-selektiven Auslese-HF-Impuls beaufschlagt, der zumindest die Kernspins in den zu selektierenden Untersuchungsbereichen auslenkt

c) unmittelbar nach dem nicht-selektiven Auslese-HF-Impuls wird das entstehende FID-Signal ausgelesen.

Dieses Verfahren hat den Vorteil, daß der Auslese-HF-Impuls sehr kurz gehalten werden kann, da er nicht selektiv ist. Nicht-selektive Impulse können nämlich im Gegensatz zu selektiven Impulsen ein beliebig breites Frequenzband aufweisen, was im Zeitbereich einer im Idealfall gegen O gehenden Zeitspanne entspricht. Damit steht das FID-Signal praktisch mit seiner vollen Anfangsamplitude zur Verfügung, so daß auch Kerne mit kurzer $T_2$-Zeit problemlos untersucht werden können.

Der auszuwertende Volumenbereich kann auch durch selektive Sättigung mehrerer Schichten eingegrenzt werden. D amit ist ein räumlich exakt definierbarer Volumenbereich abgrenzbar.

Ein Ausführungsbeispiel der Erfindung wird nachfolgend anhand der Figuren 1 bis 10 näher erläutert.

Figur 1 zeigt den Aufbau eines Gerätes für die kernmagnetische Spektroskopie,

Figur 2 zeigt ein Beispiel für eine selektive Sättigung einer Schicht,

die Figuren 3 bis 5 zeigen ein erstes Beispiel für eine Anregesequenz,

die Figuren 6 bis 10 zeigen ein zweites Beispiel für eine Anregesequenz,

Figur 11 zeigt ein Beispiel für die selektive Sättigung zweier paralleler Schichten.

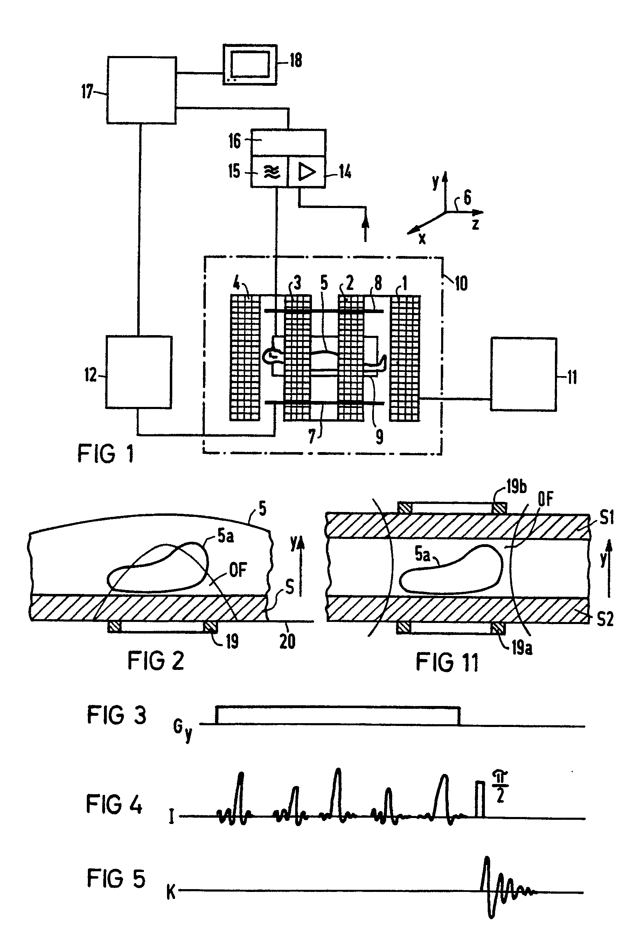

Die Figur 1 zeigt schematisch den prinzipiellen Aufbau eines Gerätes für die Erstellung von Spektren eines Untersuchungsobjektes. Mit 1 und 2 sowie 3 und 4 sind Spulen gekennzeichnet, die ein magnetisches Grundfeld $B_0$ erzeugen, in welchem sich bei Anwendung zur medizinischen Diagnostik der zu untersuchende Körper 5 eines Patienten befindet. Diesem sind außerdem Gradientenspulen 7,8 zugeordnet, die zur Erzeugung eines Magnetfeldgradienten der Richtung y gemäß der Andeutung in 6 vorgesehen sind. Die Anordnung enthält außerdem noch eine zur Erzeugung der Kernresonanzsignale dienende Ganzkörper-Antenne 9.

Die von einer strichpunktierten Linie 10 umgrenzten Spulen 1,2,3,4,7,8 und 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 liegen, umfaßt. Eine in Figur 1 nicht dargestellte Spule zum Empfang der Kernresonanz-Signale ist über einen Signalverstärker 14 an einen Prozeßrechner 17 gekoppelt, an dem zur Ausgabe des Spektrums ein Bildschirmgerät 18 angeschlossen ist. Die Ganzkörper-Antenne 9 ist an einen Hochfrequenzsender 15 angeschlossen. Die Komponenten 14 und 15 bilden eine Hochfrequenzeinrichtung 16 zur Signalerzeugung und -aufnahme.

Figur 2 stellt einen Ausschnitt des Untersuchungsobjektes 5 dar. Dabei liegt das Untersuchungsobjekt 5, beispielsweise ein Patient, auf einer Unterlage 20. Ein Organ 5a, das beispielsweise die Leber sein kann, soll spektroskopisch untersucht werden. Dazu wird das Untersuchungsobjekt 5 mit einer in den Figuren 3 bis 5 dargestellten Impulssequenz beaufschlagt. Zunächst wird der in Figur 3 dargestellte Gradient $G_y$ in y-Richtung eingeschaltet. Anschließend wird durch eine in Figur 4 dargestellte Folge von HF-Impulsen unterschiedlicher Amplitude selektiv die in Figur 2 mit S bezeichnete Schicht gesättigt, d.h. die vorher wegen des magnetischen Grundfeldes vorhandene Magnetisierung wird innerhalb dieser Schicht S zerstört. Die volle Schicht S wird jedoch nur dann gesättigt, wenn die HF-Impulse von der das ganze Untersuchungsobjekt 5 erfassenden Ganzkörper-Antenne 9 ausgesandt werden. Man kann aber die Hochfrequenz-Impulse auch über die in Figur 2 schematisch dargestellte Oberflächenspule 19 aussenden, wenn diese an den HF-Sender 15 angeschlossen wird. Diese beaufschlagt das Untersuchungsobjekt 5 im wesentlichen nur in einem in Figur 2 dargestellten Bereich OF. Damit wird nur der mit dem Bereich OF zusammenfallende Teil der Schicht S gesättigt. Allerdings ist der Bereich OF nicht scharf abgegrenzt.

Nach erfolgter Sättigung der nicht auszuwertenden Schicht S wird das Untersuchungsobjekt 5 mit einem HF-Impuls beaufschlagt. Damit werden im Falle der Beaufschlagung mit einer Oberflächenspule 19 im wesentlichen nur die Spins im Bereich OF, ansonsten alle Spins des Untersuchungsobjektes 5 ausgelenkt. Soweit vorher eine resultierende Magnetisierung vorhanden war, d.h. außerhalb der gesättigten Schicht S, entsteht damit ein FID-Signal, das in Figur 5 dargestellt ist. Dieses FID-Signal wird - wiederum im wesentlichen im Bereich OF - von der Oberflächenspule 19 erfaßt und über den Signalverstärker 14 dem Prozeßrechner 17 zur Auswertung zugeführt. Damit wird die Sende-Empfangs-Charakteris tik der Oberflächenspule 19 auf jeden Fall im Empfangsfall wirksam, auch wenn die Anregung über eine Ganzkörper-Antenne 9 erfolgt.

Mit der beschriebenen Anregesequenz erhält man Signalanteile des FID-Signals somit im wesentlichen aus dem Bereich OF abzüglich der Schicht S. Diese Signale werden dann spektroskopisch ausgewertet.

Das beschriebene Verfahren der Volumenselektion hat den Vorteil, daß der nicht-selektive Impuls I sehr kurz gemacht werden kann, so daß für die unmittelbar anschließende Auswertung das schnell abklingende FID-Signal nahezu mit seiner vollen Anfangsamplitude zur Verfügung steht. Die Dauer der selektiven Sättigung wirkt sich auf das FID-Signal nicht störend aus und ist nur durch die longitudinale Relaxationszeit $T_1$ begrenzt.

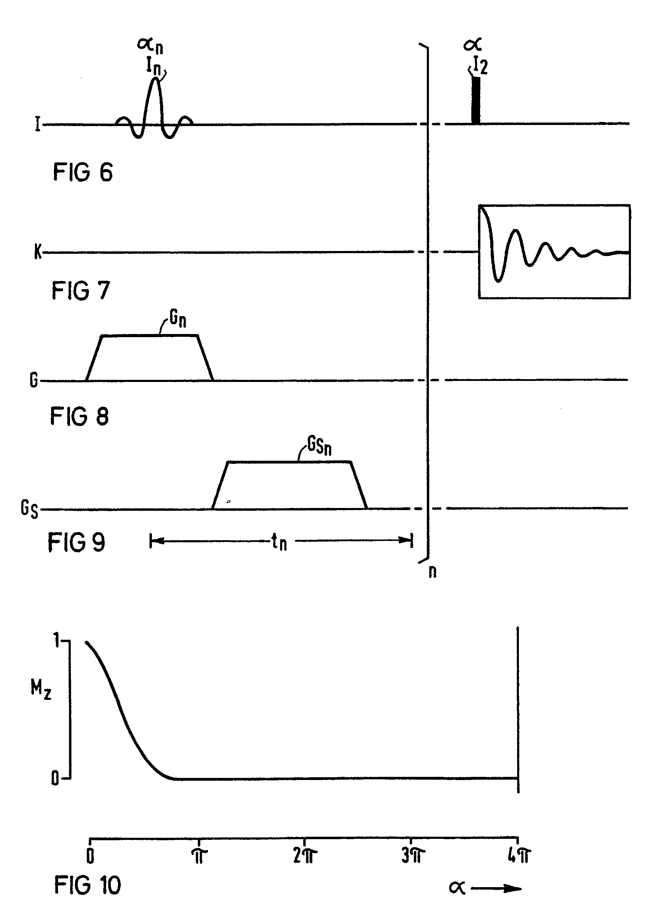

In den Figuren 6 bis 9 wird ein weiteres Ausführungsbeispiel zur selektiven Sättigung des Untersuchungsbereiches 5a durch selektive Sättigung von Schichten dargestellt. Dabei wird die dargestellte und nachfolgend beschriebene Pulssequenz n-mal angewandt. Gemäß Figur 6 wird ein frequenz-selektiver Hochfrequenzimpuls $I_n$ zusammen mit einem Gradientenimpuls $G_n$ aufgeschaltet. Damit wird die Magnetisierung in der selektierten Schicht um einen Winkel $\alpha$ gedreht. Anschließend folgt ein Spoilergradient $G_{sn}$, der eine künstliche Inhomogenität im Magnetfeld erzeugt und damit zu einer Dephasierung der Spins führt. Somit wird zunächst die transversale Magnetisierungskomponente zerstört. Diese Pulssequenz wird n-mal mit verschiedenen Hochfrequenz-Amplituden sowie mit unterschiedlicher Orientierung und Dauer des Spoilergradienten wiederholt. Auf diese Weise werden die gewünschten Schichten gesättigt.

Nach der Sättigungsphase - d.h. nach n-maliger Anwendung - existiert im Idealfall keine makroskopische Magnetisierung außerhalb des interessierenden Volumens. Die spektrale Information aus dem selektierten Volumen wird durch einen kurzen, nicht-selektiven Hochfrequenzimpuls $I_2$ gemäß Fi-

gur 6 ausgelesen. Als Antwort auf den selektiven Hochfrequenz-Impuls $I_2$ erhält man das interessierende Signal K, das in Figur 7 schematisch dargestellt ist.

Durch Variation der Amplituden und der Impulspausen t zwischen zwei Hochfrequenz-Impulsen $I_n$ kann eine Optimierung der Sättigungssequenz erreicht werden. Bei einer vorgegebenen Zahl N von Sättigungselementen wurden die besten Ergebnisse erreicht, wenn die Amplituden $A_n$ der Hochfrequenz-Impulse $I_n$ nach einer geometrischen Reihe $A_n = f^n \cdot A_1$ abnehmen. Dabei wurde ein Wert von f = 0,9 als günstig erkannt. Der Zeitabstand $t_n$ zwischen zwei aufeinanderfolgenden selektiven Hochfrequenz-Impulsen $I_n$ wird vorteilhaft festgelegt durch

$$t_n = t_1 \cdot g^n$$

Dabei hat sich ein Wert von g = 0,83 als günstig erwiesen. Damit wird die durch wiederholte Anwendung von Hochfrequenz-Impulsen erzeugte Kohärenz zerstört.

Die verbleibende longitudinale Magnetisierungskomponente des Spinsystems nach einer solchen Anregesequenz mit 10 Schritten (N = 10) wurde unter der Voraussetzung berechnet, daß die longitudinale Relaxationszeit lang in Hinblick auf die Gesamtdauer der Sättigungsperiode ist. Figur 10 zeigt, daß eine gleichzeitige Sättigung über den gesamten ausgewählten Volumenbereich erfolgt, wenn der ursprüngliche Hochfrequenz-Impuls einen Winkel $\alpha$ von mehr als $140°$ aufweist.

Bei dem bisher beschriebenen Verfahren ist der Bereich OF - wie bereits erwähnt - nicht scharf abgegrenzt. Außerdem steht die Form des auszuwertenden Volumenbereiches nicht immer in Einklang mit der Form des durch die Oberflächenspule 19 vorgegebenen Bereichs OF.

Eine schärfere Abgrenzung des auszuwertenden Volumenbereiches sowie ebene Begrenzungsflächen desselben werden möglich, wenn man gemäß Figur 11 eine weitere, zur Schicht S parallele Schicht S1 sättigt, so daß der auszuwertende Volumenbereich innerhalb des Bereichs OF durch die Schichten S und S1 begrenzt wird. Dazu müssen lediglich unter Aufschaltung des Gradienten $G_y$ weitere selektive HF-Impulse aufgeschaltet werden.

Dabei wirkt es sich als besonders vorteilhaft aus, daß die Dauer der Sättigung lediglich durch die Relaxationszeit $T_1$ begrenzt ist, während das FID-Signal von der Dauer des Sättigungsvorganges unabhängig bleibt. Die $T_1$-Relaxationszeit ist jedoch z.B. bei der in-vivo-Phosphorspektroskopie mit sehr kurzer $T_2$-Relaxationszeit verhältnismäßig lang.

Bei dem Ausführungsbeispiel nach Figur 11 wird anstelle der Oberflächenspule 19 eine den Untersuchungsbereich 5a einschließende Helmholtzspule mit zwei gegenüberliegenden Wicklungen 19a und 19b eingesetzt, die eine ebenfalls mit OF bezeichnete Sende-Empfangs-Charakteristik aufweist.

## Ansprüche

1. Verfahren zur Ermittlung von kernmagnetischen Spektren aus räumlich selektierbaren Untersuchungsbereichen (5a) eines Untersuchungsobjektes (5), das mit einem magnetischen Grundfeld und einem Gradientenfeld ($G_y$) sowie mit einer Folge von HF-Impulsen (I) zur Anregung der kernmagnetischen Resonanz beaufschlagt wird, wobei das entstehende Kernresonanzsignal (K) mit einer in der Nähe des Untersuchungsbereiches (1a) angeordneten Spule (19) erfaßt wird und wobei die räumliche Selektion durch Überlagerung der Sende-Empfangs-Charakteristik der Spule (2) mit einer selektiven Schichtanregung durch Aufschaltung eines Gradienten ($G_y$) zusammen mit einem frequenzselektiven HF-Impuls erreicht wird,
**gekennzeichnet** durch folgende Verfahrensschritte:
   a) nicht auszuwertende Volumenbereiche (S) des Untersuchungsobjektes (5) werden selektiv gesättigt,
   b) das Untersuchungsobjekt (5) wird mit einem nichtselektiven Auslese-HF-Impuls ($\pi/2$) beaufschlagt, der zumindest die Kernspins in den zu selektierenden Untersuchungsbereichen (5a) auslenkt,
   c) unmittelbar nach dem nicht-selektiven Auslese-HF-Impuls ($\pi/2$) wird das entstehende FID-Signal ausgelesen.

2. Verfahren nach Anspruch 1,
**dadurch gekennzeichnet,**
daß der zu selektierende Untersuchungsbereich (5a) durch selektive Sättigung mehrerer Schichten (S,S1) eingegrenzt wird.

3. Verfahren nach Anspruch 1 oder 2,
**dadurch gekennzeichnet,**
daß die Sättigung durch eine Folge (I) von HF-Impulsen unterschiedlicher Amplitude erreicht wird, die gleichzeitig mit einem Gradienten ($G_y$) aufgeschaltet werden.

4. Verfahren nach Anspruch 2,
**dadurch gekennzeichnet,**
daß die Sättigung durch n-fache Wiederholung folgender Pulssequenz erreicht wird:

a) ein frequenz-selektiver HF-Impuls ($I_n$) wird gleichzeitig mit einem Gradienten ($G_n$) aufgeschaltet,

b) nach dem frequenz-selektiven HF-Impuls ($I_n$) wird ein Spoiler-Gradient ($G_{sn}$) aufgeschaltet,

wobei bei jeder Pulssequenz die Amplitude des frequenz-selektiven HF-Impulses ($I_n$) und die Richtung sowie die Dauer des Spoiler-Gradienten ($G_{sn}$) geändert werden.

## Claims

1. Process for the identification of nuclear magnetic spectra from spatially selectable examination regions (5a) of an object under examination (5), which is acted on by a basic magnetic field and a gradient field ($G_y$) and by a sequence of HF-pulses (I) for exciting the nuclear magnetic resonance, the resultant nuclear resonance signal (K) being detected using a coil (19) arranged near the examination region (1a) and the spatial selection being achieved by superimposing the transmission/reception characteristic of the coil (2) with a selective layer excitation by applying a gradient ($G_y$) together with a frequency-selective HF pulse, characterised by the following process steps:

    a) volume regions (5) of the object under examination (5) which are not to be evaluated are selectively saturated,

    b) the object under examination (5) is acted on by a non-selective read-out HF-pulse ($\pi/2$) which deflects the nuclear spin at least in the examination regions (5a) to be selected,

    c) directly after the non-selective read-out HF-pulse ($\pi/2$) the resultant FID signal is read out.

2. Process according to claim 1, characterised in that the examination region (5a) to be selected is bounded by selective saturation of a plurality of layers (S, S1).

3. Process according to claim 1 or 2, characterised in that saturation is achieved by a sequence (I) of HF-pulses of different amplitude which are applied simultaneously with a gradient ($G_y$).

4. Process according to claim 2, characterised in that saturation is achieved by repeating the following pulse sequence n times:

    a) a frequency-selective HF-pulse ($I_n$) is applied simultaneously with a gradient ($G_n$),

b) after the frequency-selective HF pulse ($I_n$) a spoiler gradient ($G_{sn}$) is applied, the amplitude of the frequency-selective HF pulse ($I_n$) and the direction and duration of the spoiler gradient ($G_{sn}$) being changed with each pulse sequence.

## Revendications

1. Procédé pour l'obtention de spectres de résonnance magnétique nucléaire dans des régions d'examen (5a) sélectionnées spatialement d'un objet à examiner (5) qui est chargé avec un champ magnétique de base et avec un champ irritationel ($G_y$) ainsi qu'avec un train d'impulsion HF (J) pour exciter la résonnance magnétique nucléaire, dans lequel le signal de résonnance nucléaire (K) qui se forme est saisi a l'aide d'une bobine (19) qui est disposée dans le voisinage de la région à examiner (1a) et dans lequel la sélection spatiale est obtenue par la superposition de la caractéristique émission-réception de la bobine (2) avec une excitation sélective de la couche par application d'un gradient ($G_y$) y compris d'une impulsion HF sélective du point de vue de la fréquence, caractérisé par les opérations suivantes :

    a) on sature sélectivement des portions de volume (S) de l'objet à examiner (5), qui ne sont pas à évaluer,

    b) on charge l'objet à examiner (5) avec une impulsion de lecture HF non sélective ($\pi/2$) qui dévie au moins le spin nucléaire dans les régions à examiner (5a) qui sont à sélectionner, et

    c) on procéde immédiatement à la suite de l'impulsion de lecture HF non sélective ($\pi/2$), à la lecture du signal FID qui se forme.

2. Procédé selon la revendication 1, caractérisé par le fait que la région à examiner (5a) qui est à sélectionner, est délimitée par saturation de plusieurs couches (S, S1).

3. Procédé selon la revendication 1 ou 2, caractérisé par le fait que la saturation est obtenue par un train (I) d'impulsions HF d'amplitudes différentes et qui sont appliquées en même temps g'un gradient ($G_y$).

4. Procédé selon la revendication 2, caractérisé par le fait que la saturation est obtenue en répétant n fois la séquence impulsionnelle suivant des fréquences :

    a) une impulsion HF ($I_n$) sélective en fré-

quence est appliquée en même temps qu'un gradient ($G_n$),

b) à la suite de l'impulsion HF ($I_n$) sélective en fréquence, on applique un gradient perturbateur ($G_{sn}$), la réalisation étant telle que pour chaque séquence d'impulsion, l'amplitude de l'impulsion HF ($I_n$) sélective en fréquence et la direction de même que la durée du gradient perturbateur ($G_{sn}$) sont modifiées.

FIG 1

FIG 2

FIG 11

FIG 3 $G_y$

FIG 4 I

FIG 5 K

$\alpha_n$

$I_n$

I

FIG 6

$\alpha$

$I_2$

K

FIG 7

$G_n$

G

FIG 8

$GS_n$

GS

FIG 9

$t_n$

n

$M_z$

1

0

FIG 10

0    $\pi$    $2\pi$    $3\pi$    $4\pi$

$\alpha$